# FASCICULE DE BREVET EUROPEEN

(11) **EP 2 186 093 B1**
(45) Date de publication et mention de la délivrance du brevet: **02.12.2015**
(21) Numéro de dépôt: 08787215.6
(22) Date de dépôt: 14.08.2008
(51) Int. Cl.: G11C 5/06, G11C 5/02, G11C 7/10, G11C 8/12

(54) **MÉMOIRE PARTAGÉE**
GEMEINSAM BENUTZTER SPEICHER
SHARED MEMORY

(30) Priorité: 29.08.2007 FR 0706035
(43) Date de publication de la demande: 19.05.2010
(73) Titulaire: Commissariat à l'Énergie Atomique et aux Énergies Alternatives, 75015 Paris (FR)
(72) Inventeur: HARRAND, Michel, F-38120 Saint-egreve (FR)
(74) Mandataire: Lucas, Laurent Jacques
(86) Numéro de dépôt international: PCT/EP2008/060675
(87) Numéro de publication internationale: WO 2009/027236

(56) Documents cités:
- EP-A- 0 420 339
- US-A- 5 875 470
- US-A- 6 151 256
- US-A1- 2005 249 020

## Description

La présente invention concerne une mémoire partagée notamment par plusieurs processeurs intégrés dans un même circuit à base de semi-conducteurs. La mémoire partagée trouve notamment son application dans le domaine de la microélectronique.

Dans un système multiprocesseur, les processeurs peuvent travailler en parallèle sur une même application. Il est donc nécessaire que les processeurs puissent s'échanger entre eux un nombre important de données. Afin de réduire le temps de transfert des données entre les processeurs, il est avantageux que tous les processeurs aient accès à une même mémoire. Un premier processeur peut ainsi travailler sur une première tâche puis mettre à jour des premières données dans la mémoire en fonction des résultats qu'il a obtenu. Il peut ensuite signaler à un deuxième processeur que les premières données de la mémoire sont prêtes pour subir un autre traitement. Le deuxième processeur peut alors utiliser les premières données de la mémoire dans une deuxième tâche. Pendant ce temps, le premier processeur peut traiter d'autres données.

Afin que le partage de la mémoire par plusieurs processeurs ne ralentisse pas les traitements des processeurs, une méthode connue est de diviser la mémoire en plusieurs bancs de mémoire indépendants. De cette manière, tant que les processeurs travaillent chacun avec un banc de mémoire différent, le partage de la mémoire ne ralentit pas leurs traitements.

Il convient pour une telle mémoire partagée d'utiliser une conception qui permette à la fois une réduction des coûts de production et une optimisation des vitesses de transfert des données. Différentes conceptions de mémoire partagée ont été proposées, comme par exemple dans US 2005/249020 A1, US 6 151 256 A ou EP 0 420 339 A.

Une solution existante utilise des multiplexeurs connectés en leur sortie sur une entrée des bancs mémoire. Les entrées des multiplexeurs sont connectées aux sorties des différents processeurs devant avoir accès à la mémoire. Un bus de données d'entrée de chaque processeur est connecté à une sortie d'un multiplexeur recevant en entrée les bus de données de sortie de tous les bancs mémoire.

Un problème rencontré avec cette mise en oeuvre est le nombre important de connexions nécessaires. En particulier, les connexions reliant les bus de données de sortie des bancs de mémoire avec les multiplexeurs situés sur les bus de données d'entrée des processeurs sont en nombre important. La surface de ces connexions peut être supérieure à la surface des mémoires et la surface totale de la mémoire partagée peut ainsi être doublée. Une telle augmentation de la surface d'une mémoire partagée engendre des coûts de production importants. De plus la longueur importante de ces connexions induit notamment une capacité parasite importante. Cette capacité parasite peut ralentir le transfert de données et causer une consommation d'énergie importante.

Une autre solution existante est de connecter plusieurs processeurs à une même mémoire multi-ports. Une mémoire multi-ports est une mémoire comportant un nombre k d'entrées/sorties. La mémoire multi-ports comporte par exemple plusieurs cellules mémoire, chaque cellule mémoire comportant un nombre k de commutateurs. Les k commutateurs de chaque cellule mémoire permettent de connecter chaque cellule mémoire à un bus de données de sortie mémoire, parmi k bus de données de sortie mémoire. Une telle mémoire permet à k processeurs d'avoir un accès à ladite mémoire. Cependant cette autre solution nécessite également un nombre important de connexions. Ceci implique qu'un composant intégrant une telle mémoire est de taille relativement importante.

Le brevet US5875470 décrit notamment une mémoire offrant à plusieurs processeurs un accès simultané en lecture écriture sur les données qu'elle contient.

Un but de l'invention est notamment de pallier les inconvénients précités. A cet effet, l'invention a pour objet une mémoire partagée réalisée sur un premier circuit intégré à base de semi-conducteurs telle que décrit dans les revendications.

L'invention a notamment pour principaux avantages de permettre la production d'une mémoire partagée, ayant des vitesses d'accès aux données importantes ainsi qu'une consommation d'énergie réduite, à faible coût.

D'autres caractéristiques et avantages de l'invention apparaîtront à l'aide de la description qui suit, donnée à titre illustratif et non limitatif, et faite en regard des dessins annexés qui représentent :
- la figure 1a : un exemple d'architecture de mémoire partagée par plusieurs processeurs selon l'art antérieur ;
- la figure 1b : un exemple d'architecture d'une mémoire multi-ports selon l'art antérieur ;
- la figure 2 : un premier exemple d'architecture de mémoire partagée par plusieurs processeurs selon l'invention ;
- la figure 3 : un exemple détaillé d'une interconnexion selon l'invention entre un banc mémoire et un processeur ;
- la figure 4 : un chronogramme de fonctionnement d'une lecture de donnée sur un banc de la mémoire partagée selon l'invention ;
- la figure 5 : un deuxième exemple d'architecture d'une mémoire partagée selon l'invention ;
- la figure 6 : un troisième exemple schématique d'architecture d'une mémoire partagée selon l'invention.

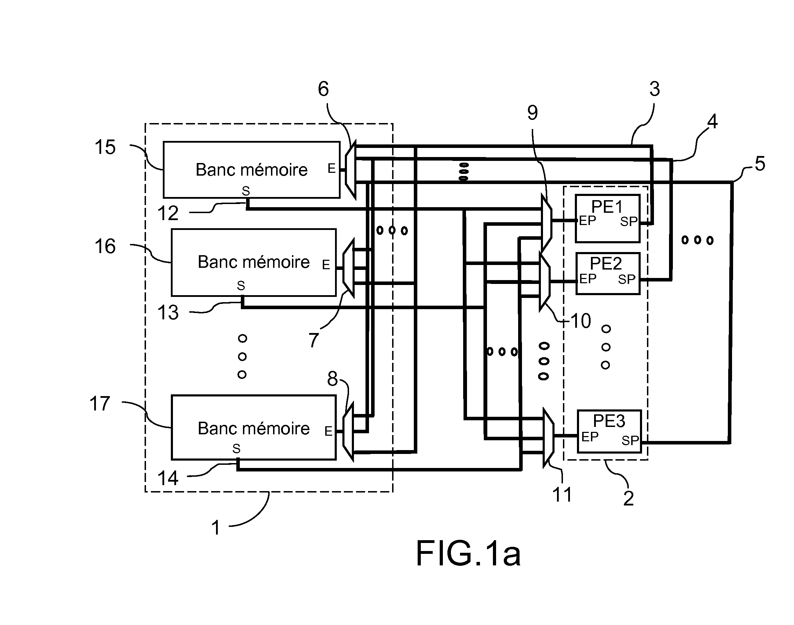

La figure 1a représente, de manière schématique une architecture d'une première mémoire partagée 1 par un ensemble de plusieurs processeurs élémentaires 2, selon l'art antérieur.

Par exemple la première mémoire partagée 1 peut comporter un nombre b de bancs mémoire. Sur la figure 1a, trois bancs mémoire sont représentés pour l'exemple : un premier banc mémoire 15, un deuxième banc mémoire 16 et un troisième banc mémoire 17. Chaque banc mémoire 15, 16, 17 comporte notamment une entrée E et une sortie S. Chaque entrée E de chaque banc mémoire 15, 16, 17 est reliée à un multiplexeur 6, 7, 8, nommé le multiplexeur d'entrée mémoire 6, 7, 8. Chaque sortie S de chaque banc mémoire 15, 16, 17 est reliée à un premier bus de données mémoire 12, 13, 14 propre à chaque banc mémoire 15, 16, 17.

La mémoire partagée 1 peut être partagée par un nombre n de processeurs élémentaires 2. Sur la figure 1a, trois processeurs élémentaires sont représentés: un premier processeur élémentaire PE1, un deuxième processeur élémentaire PE2, et un troisième processeur élémentaire PE3. Chaque processeur élémentaire PE1, PE2, PE3 comporte un bus de données et d'adresses processeur 3, 4, 5, connecté à sa sortie SP. Un bus de données et d'adresses permet de véhiculer des signaux comportant des données, des adresses mais également des signaux de contrôle. Les signaux de contrôle permettent de commander la mémoire. Les signaux de contrôle peuvent notamment commander : une activation de la mémoire, une lecture et une écriture de données en mémoire et éventuellement un séquencement des opérations précédemment nommées.
Chaque processeur élémentaire PE1, PE2, PE3 comporte une entrée EP reliée à un multiplexeur d'entrée processeur 9, 10, 11.

Chaque bus de données et d'adresses de chaque processeur 3, 4, 5 est relié aux multiplexeurs d'entrée mémoire 6, 7, 8. Le bus de données et d'adresses processeur 3, 4, 5 peut permettre d'écrire en mémoire une ou plusieurs données calculées par un processeur élémentaire PE1, PE2, PE3 par exemple. Le bus de données et d'adresses processeur 3, 4, 5 permet également au processeur élémentaire PE1, PE2, PE3 d'effectuer des requêtes de données stockées dans la mémoire partagée 1. Les multiplexeurs d'entrée mémoire 6, 7, 8 permet par exemple de sélectionner quelles données venant des différents processeurs élémentaires PE1, PE2, PE3 doivent arriver dans chacun des bancs mémoire 15, 16, 17.

Chaque sortie S de chaque banc mémoire 15, 16, 17 est reliée à chaque multiplexeur d'entrée processeur 9, 10, 11 par l'intermédiaire des bus de données mémoire 12, 13, 14. Chaque multiplexeur d'entrée processeur 9, 10, 11 est donc connecté à l'ensemble des premiers bus de données mémoire 12, 13, 14 de chaque banc mémoire 15, 16, 17.

Ce type d'architecture de mémoire partagée nécessite donc un grand nombre de connexions occupant une surface importante de la mémoire partagée. De plus la longueur des connexions implique une capacité parasite importante.

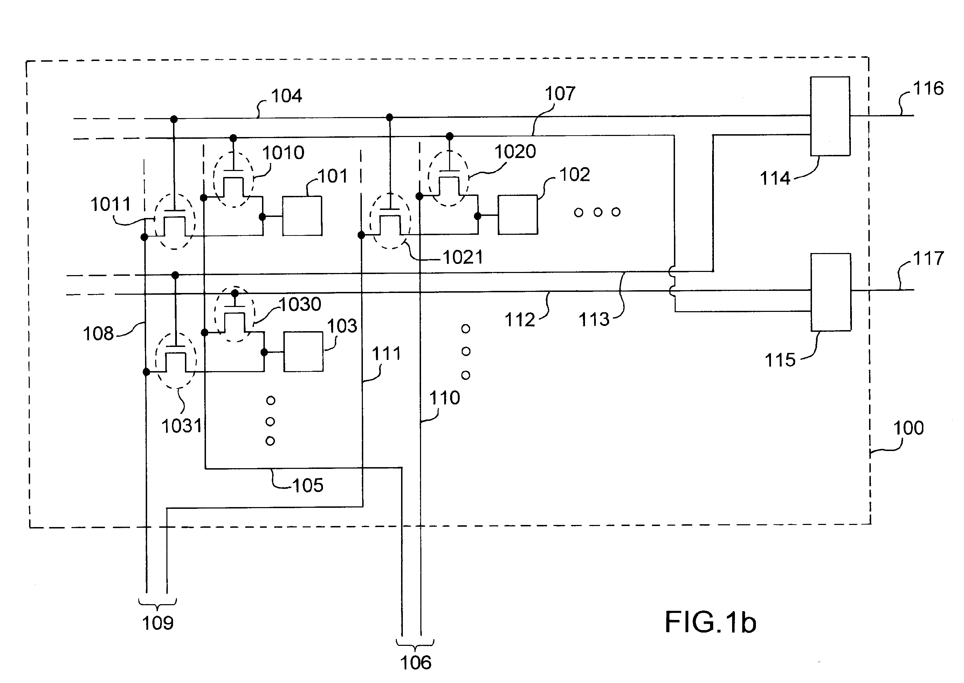

La figure 1b représente de manière simplifiée une mémoire multi-ports 100, selon l'art antérieur, réalisée sur une puce à base de semi-conducteurs. La mémoire multi-ports 100 comporte notamment plusieurs ports d'entrées/sorties sur lesquels peuvent se connecter plusieurs processeurs, non représentés sur la figure 1 b. La mémoire multi-ports 100 comporte plusieurs cellules mémoire 101, 102, 103. Sur la figure 1b, trois cellules mémoire 101, 102, 103 sont représentées. Chaque cellule mémoire 101, 102, 103 est connectée à un nombre entier k de commutateurs. Sur la figure 1b, chaque cellule mémoire 101, 102, 103 est connectée à deux commutateurs 1010, 1011, 1020, 1021, 1030, 1031. Par exemple une entrée/sortie d'une première cellule mémoire 101 est connectée à un premier commutateur 1010, et à un deuxième commutateur 1011.

Le premier commutateur 1010 est relié d'une part à une première ligne de mots 107, et d'autre part à un premier fil 105 d'un premier bus de données 106. Le premier bus de données 106 est par exemple relié à une broche d'un port d'entrée/sortie de la mémoire multi-ports 100.

De la même manière, le deuxième commutateur 1011 est relié d'une part à une deuxième ligne de mots 104, et d'autre part à un premier fil 108 d'un deuxième bus de données 109.

Comme la première cellule mémoire 101, une deuxième cellule mémoire 102 est connectée à deux commutateurs: un troisième commutateur 1020 et un quatrième commutateur 1021. Le troisième commutateur 1020 est connecté d'une part à la première ligne de mots 107 et d'autre part à un deuxième fil 110 du premier bus de données 106. Le quatrième commutateur 1021 est connecté d'une part à la deuxième ligne de mots 104, et d'autre part à un deuxième fil 111 du deuxième bus de données 109.

Une troisième cellule mémoire 103 est, de la même manière, connectée à un cinquième commutateur 1030 et à un sixième commutateur 1031. Le cinquième commutateur 1030 est connecté d'une part à une troisième ligne de mots 112 et d'autre part au premier fil 105 du premier bus de données 106. Le sixième commutateur 1031 est connecté d'une part à une quatrième ligne de mots 113 et d'autre part au premier fil 108 du deuxième bus de données 109.

De manière générale, chaque cellule mémoire 101, 102, 103, est connectée à chaque bus de donnée 109, 106.

Chaque ligne de mot 104, 107, 112, 113 est connectée à un décodeur de ligne de mots 114, 115. La première ligne de mots 107 est connectée à un premier décodeur de ligne de mots 114, la deuxième ligne de mots 104 est, quant à elle, connectée à un deuxième décodeur de ligne de mots 115. De la même manière, la troisième ligne de mots 112 est connectée au deuxième décodeur de ligne de mots 115 et la quatrième ligne de mots 113 est connectée au premier décodeur de ligne de mots 114.

Chaque décodeur de ligne de mot 114, 115, prend donc en entrée plusieurs lignes de mots 104, 107, 112, 113. Une sortie de chaque décodeur de ligne de mot 114, 115, est connectée à un bus d'adresse 116, 117. Par exemple, le premier décodeur de ligne de mots 114 est connecté à un premier bus d'adresses 116 et le deuxième décodeur de ligne de mots 117 est connecté à un deuxième bus d'adresses 117. Les deux bus d'adresses 116, 117 sont reliés à un port d'entrée/sortie de la mémoire multi-ports 100.

Une telle mémoire multi-ports 100 représentée sur la figure 1b, est une mémoire double port, elle offre donc un accès en écriture et en lecture à deux processeurs. De manière générale, une mémoire multi-ports permet à un nombre k de processeurs de se connecter. k est notamment le nombre de :
- commutateurs 1010, 1011, 1020, 1021, 1030, 1031 reliés à chaque cellule mémoire ;
- lignes de mots ;
- bus de données.

Une mémoire multi-ports, si elle fournit un accès mémoire à plusieurs processeurs en parallèle, possède une surface importante notamment due au nombre important de connexions à réaliser.

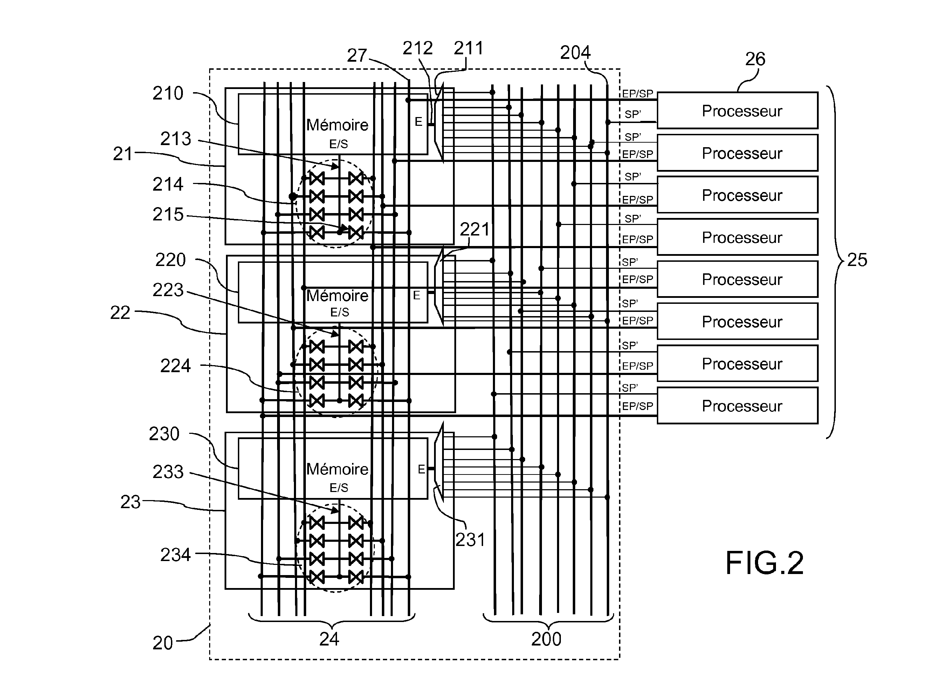

La figure 2 représente de façon schématique un exemple d'une structure d'une mémoire partagée 20 selon l'invention.

La structure de la mémoire partagée 20 selon l'invention comporte par exemple un nombre p de bancs mémoire 21, 22, 23, p étant un nombre entier par exemple supérieur à deux. Sur la figure 2 et à titre d'exemple, trois des p bancs mémoire 21, 22, 23 sont représentés. Chacun des p bancs mémoire 21, 22, 23 comporte :
- une mémoire 210, 220, 230 ;
- un multiplexeur 211, 221, 231 ;
- un bus de données mémoire 213, 223, 233 ;
- un bloc de commutateurs 214, 224, 234.

Les mémoires 210, 220, 230 peuvent être des mémoires à simple port, par exemple de type SRAM, acronyme pour l'expression anglo-saxonne Static Random Access Memory signifiant mémoire vive statique. Des mémoires de type SRAM permettent notamment un accès rapide aux données stockées par les-dites mémoires.

La mémoire partagée 20 est partagée par un nombre m de processeurs 25, m étant un nombre entier par exemple supérieur à un. Sur la figure 2, huit des m processeurs 25 sont représentés par exemple. Les m processeurs 25 peuvent être des processeurs élémentaires.

La mémoire partagée 20 est décrite dans la suite plus particulièrement pour un premier banc mémoire 21 et un premier processeur 26, cette même description peut s'appliquer à l'ensemble des p bancs mémoires 21, 22, 23 et à l'ensemble des m processeurs 25.

La structure de la mémoire partagée 20 comporte en outre un ensemble de m bus parallèles bidirectionnels de données 24, par exemple. Dans un mode de réalisation d'une mémoire partagée 20 selon l'invention, les bus parallèles de données 24 peuvent se situer physiquement, au-dessus des p bancs mémoire 21, 22, 23. Les p bancs mémoires 21, 22, 23 peuvent par exemple se situer dans un même plan. Placer les bus parallèles de données 24 physiquement au-dessus des p bancs mémoire 21, 22, 23 permet d'économiser la surface de silicium utilisée pour réaliser la mémoire partagée 20 selon l'invention. L'économie de silicium réalisée permet avantageusement d'améliorer le coût de production d'une mémoire partagée 20 selon l'invention. Les bus parallèles de données 24 peuvent être par exemple des bus de trente-deux bits ou de soixante-quatre bits ou encore de cent vingt-huit bits. Les bus parallèles de données 24 peuvent être des bus différentiels.
Chacun des bus parallèles de données 24 peut permettre de recevoir une donnée venant de l'un des p bancs mémoire 21, 22, 23, ou bien de transmettre une donnée vers ces bancs mémoire, via les bus 213, 223, 233. Ces transferts peuvent se faire simultanément depuis ou vers les m processeurs 25, à raison d'autant de transferts simultanés qu'il y a de bus de données 24 (en supposant un nombre de bancs mémoire supérieur ou égal au nombre de bus de données 24).
Les bus parallèles de données 24 peuvent représenter des entrées/sorties de données EP/SP de la mémoire partagée 20 ou être physiquement raccordés à des entrées/sorties de données EP/SP de la mémoire partagée 20.

Les entrées/sorties de données EP/SP de la mémoire partagée 20 font partie des interfaces d'entrées/sorties de la mémoire partagée 20 avec des composants électroniques extérieurs à la mémoire partagée 20. Sur la figure 2, chaque interface d'entrée/sortie de la mémoire partagée 20 est connectée avec un des m processeurs 25. Chaque bit d'une entrée/sortie de donnée EP/SP de la mémoire partagée 20 peut être réalisé sur un même fil ou sur deux fils séparés, réalisant ainsi une liaison différentielle.

Chacun des m bus parallèles de données 24 correspond à l'un des m processeurs 25. Par exemple, sur la figure 2, chacun des m processeurs 25 est relié à l'un des m bus parallèles 24. Ainsi les données entrant et sortant de chacun des m processeurs 25 circulent sur l'un des m bus parallèles 24 de données correspondants. Par exemple le premier processeur 26 est connecté à un premier bus parallèle de données 27 par l'intermédiaire d'une première entrée/sortie EP/SP de la mémoire partagée 20. Le premier bus parallèle de données 27 est lui-même connecté à un premier bus de données mémoire 213 du premier banc mémoire 21 par l'intermédiaire d'un premier commutateur 215. Le premier commutateur 215 fait partie d'un premier ensemble 214 de commutateurs du premier banc mémoire 21. Le premier bus de données mémoire 213 est notamment connecté à une entrée/sortie de données E/S d'une première mémoire 210 faisant partie du premier banc mémoire 21. Les bus de données mémoire 213, 223, 233 peuvent être des bus différentiels. Le premier commutateur 215 permet notamment de sélectionner des données provenant notamment du premier banc mémoire 21 à faire circuler sur le premier bus parallèle de données 27 en phase de lecture de la mémoire partagée 20 par le premier processeur 26.

Chacun des m bus parallèles de données 24 est relié à une entrée/sortie de données E/S de chacune des mémoires 210, 220, 230 des p bancs mémoire 21, 22, 23 par l'intermédiaire d'un commutateur parmi chaque ensemble 214, 224, 234 de commutateurs de chacun des p bancs mémoire 21, 22, 23. Ainsi chacun des p bancs mémoire 21, 22, 23 dispose d'un nombre m de commutateurs lui permettant de distribuer des données des mémoires 210, 220, 230 sur l'ensemble des m bus parallèles de données 24. Ceci revient à répartir une fonction de multiplexeurs connectés aux m bus parallèles de données 24, sur chacun des p bancs mémoire 21, 22,23.

La mémoire partagée 20 comporte également un ensemble de m bus parallèles d'adresses et de contrôle 200 rassemblant les bus d'adresses et de contrôle de chacun des m processeurs 25. Un des bus d'adresses et de contrôle 200, comme un premier bus d'adresse et de contrôle 204, permet notamment de transmettre des signaux d'adresses mais également des signaux de contrôle. Les signaux de contrôle permettent notamment de commander les mémoires 210, 220, 230. Une commande d'une mémoire 210, 220, 230 peut être une commande :
- d'activation de la mémoire 210, 220, 230 ;
- d'opérations de lecture et d'écriture de la mémoire 210, 220, 230 ;
- et, éventuellement de mise en séquence, ou séquencement, des différentes opérations effectuées par la mémoire 210, 220, 230.

Les bus d'adresses et de contrôle 200 sont connectés à m entrées d'adresses et de contrôle SP' de la mémoire partagée 20. Par exemple le premier bus d'adresses et de contrôle 204, faisant partie des bus d'adresses et de contrôle 200, est connecté à une entrée d'adresses et de contrôle SP' de la mémoire partagée 20. L'entrée d'adresses et de contrôle SP' de la mémoire partagée 20 est connectée à un bus d'adresses et de contrôle du premier processeur 26. Les entrées d'adresses et de contrôle SP' font parties des interfaces d'entrées/sorties EP/SP, SP' de la mémoire partagée 20.

Chaque bus d'adresses et de contrôle 200 est connecté à chacun des p bancs mémoire 21, 22, 23. En particulier, chaque bus d'adresses et de contrôle 200 est connecté à une entrée de chaque multiplexeur 211, 221, 231 de chacun des p bancs mémoire 21, 22, 23. Le bus d'adresses et de contrôle 204 est connecté à une entrée d'un premier multiplexeur 211 faisant partie du premier banc mémoire 21. Le bus d'adresses et de contrôle 204 est également connecté à une entrée d'un deuxième multiplexeur 221 faisant partie d'un deuxième banc mémoire 22, ainsi qu'à une entrée d'un troisième multiplexeur 231, faisant partie d'un troisième banc mémoire 23.

Chaque multiplexeur 211, 221, 231 est relié à une entrée de commande et de contrôle E d'une mémoire 210, 220, 230. Par exemple, une entrée de commande et de contrôle E de la première mémoire 210 est connectée à la sortie du premier multiplexeur 211.

Les bus parallèles d'adresses et de contrôle 200 permettent de véhiculer vers les p bancs mémoires 21, 22, 23 des requêtes de chacun des m processeurs 25.

Les connexions entre les p bancs mémoires 21, 22, 23 et les m processeurs 25 se font donc via les m bus parallèles de données 24 et les bus parallèles d'adresses et de contrôle 200. Chaque processeur 25 est donc connecté à l'un des m bus parallèles de données 24 et à l'un des m bus parallèles d'adresses et de contrôle 20, ce qui permet l'accès à des segments de données courts. Les connexions entre les p bancs mémoires 21, 22, 23 et les m processeurs 25 n'engendrent donc pas ou peu de surface supplémentaire par rapport à la surface occupée par les p bancs mémoires 21, 22, 23, ces connexions pouvant par exemple être réalisées physiquement au-dessus des p bancs mémoire 21, 22, 23.

La mémoire partagée 20 ainsi que les m processeurs 25 peuvent être intégrés sur une première puce à base de semi-conducteurs par exemple. Les bus parallèles de données 24, les bus d'adresses et de contrôle 200 peuvent être réalisés dans des couches de métaux situées physiquement au-dessus des couches réalisant les p bancs mémoires 21, 22, 23. Les p bancs mémoires 21, 22, 23 sont en effet réalisés à l'aide, entre autres, de plusieurs couches de métaux différentes. En d'autres termes, les bus parallèles de données 24, les bus d'adresses et de contrôle 200 peuvent être réalisés dans des couches de métaux superposées aux couches réalisant les p bancs mémoires 21, 22, 23. La réalisation des p mémoires 210, 220, 230 est par ailleurs connue de l'homme du métier.

De plus, afin de réduire l'impact de la longueur des connexions sur la vitesse de transfert des données et la consommation en énergie de la puce comportant ces mémoires, les connexions peuvent être réalisées de manière différentielle. Ceci revient à doubler chaque connexion et à réunir chaque paire de connexion par un amplificateur différentiel permettant ainsi d'utiliser une faible excursion en tension du signal véhiculé par les connexions. Une telle réalisation est décrite plus précisément par la suite. Un dispositif similaire est couramment utilisé sur les lignes de bit des mémoires par exemple.

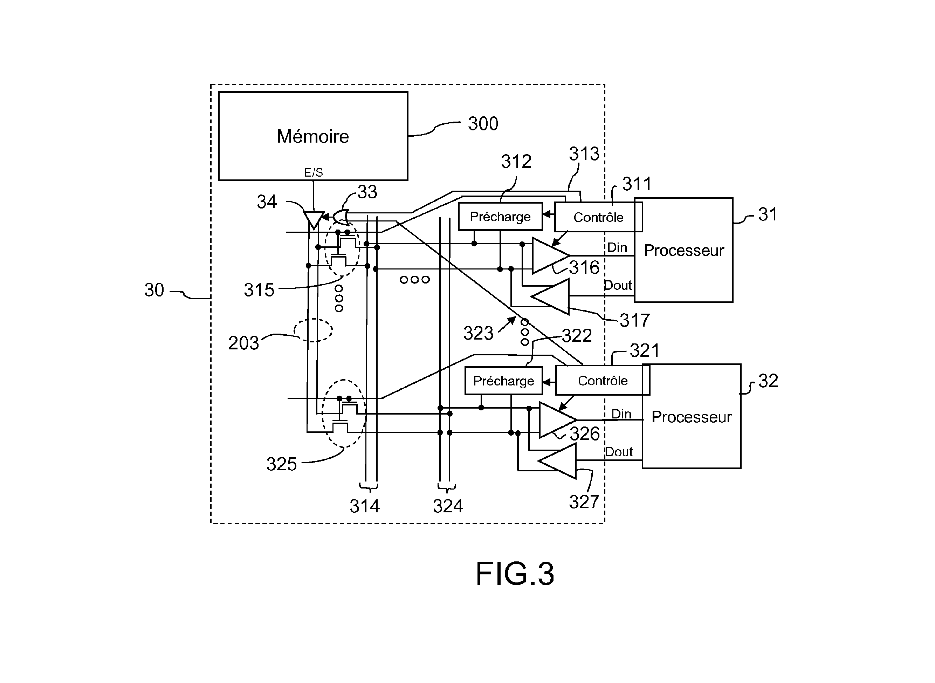

La figure 3 représente un exemple détaillé d'une réalisation d'une interconnexion entre un quatrième banc mémoire 30, faisant partie de la mémoire partagée 20 selon l'invention, et un deuxième processeur 31. La figure présente également une interconnexion entre le quatrième banc mémoire 30 et un troisième processeur 32. Le deuxième processeur 31 et le troisième processeur 32 font, par exemple, partie des m processeurs 25 représentés sur la figure 2.

Lorsque le processeur 31, 32 veut lire le contenu d'un mot stocké dans une deuxième mémoire 300 du quatrième banc mémoire 30, un module de contrôle 311, 321 associé au processeur 31, 32 envoie une requête de lecture au quatrième banc mémoire 30. On peut, par exemple, mettre en oeuvre :
- soit un module de contrôle 311, 321 par processeur 31, 32, comme c'est le cas sur la figure 3,
- soit un module de contrôle par banc mémoire dans un autre mode de réalisation.
En effet, un module de contrôle 311 peut contrôler notamment un des p bancs mémoire 21, 22, 23 et l'un des m processeurs 25. L'utilisation d'un module de contrôle par processeur est notamment avantageuse lorsque l'on dispose d'un nombre plus important de bancs mémoires par rapport au nombre de processeurs.

La requête de lecture passe notamment par les bus d'adresses et de contrôle 200 représentés sur la figure 2. Les bus d'adresses et de contrôle 200 comprennent notamment un fil 313, 323, représenté sur la figure 3, véhiculant un signal de séquencement du processeur 31, 32 servant à commander le driver du bus 203 au moment opportun. Dans la suite, les fils 313, 323 sont nommés signaux de séquencement 313, 323.

Un arbitre, non représenté sur la figure 3, sélectionne la requête et commande une ligne de mot du quatrième banc mémoire 30 associée à une adresse contenue dans la requête de lecture. L'arbitre est une fonction logique permettant de mettre en attente des requêtes de lecture venant, par exemple, des différents processeurs 31, 32. Plusieurs réalisations sont possibles pour la fonction d'arbitrage :
- une première réalisation, dite arbitre à priorité tournante, peut considérer que chaque processeur 31, 32, est prioritaire à tour de rôle ;
- une deuxième réalisation, dite arbitre à priorité fixe, peut assigner une priorité fixe à chaque processeur 31, 32 par exemple.
L'arbitre à priorité fixe est relativement simple à mettre en oeuvre. L'arbitre à priorité tournante permet une même rapidité d'accès à la mémoire partagée 20 par tous les différents processeurs 31, 32. L'arbitre à priorité fixe permet également de mieux maîtriser le temps d'accès le plus défavorable. Un arbitre permettant une sélection du bus d'adresses et de contrôle 200 représenté sur la figure 2, à prendre en compte, peut utiliser un multiplexeur, comme le premier multiplexeur 211 représenté sur la figure 2. Les différentes réalisations possibles d'un arbitre sont bien connues de l'homme du métier.

Lors de l'envoi d'une requête de lecture à la deuxième mémoire 300, celle-ci traite alors cette requête et renvoie les données collectées sur une entrée/sortie E/S de données de la deuxième mémoire 300. Une fois la lecture de données effectuée par la mémoire 300, le module de contrôle 311, 321 du processeur 31, 32 active le signal de séquencement 313, 323. Le signal de séquencement est destiné à connecter la sortie S de la deuxième mémoire 300 sur un deuxième bus de données mémoire 203. Le signal de séquencement 313, 323 est connecté à un composant de commande 33. Le composant de commande 33 permet de contrôler le fonctionnement d'un ou plusieurs drivers 34. Un driver 34 est un composant électronique pilote. Les drivers 34 sont chargés de connecter la sortie S de la mémoire 300 aux bus parallèles de données 24. Les bus parallèles de données 24 sont représentés par deux couples de fils 314, 324, chaque couple de fils 314, 324 étant relié à l'un des processeurs 31, 32. Par extension, dans la suite, les deux couples de fils 314, 324 sont nommés bus de données 314, 324. Chacun des deux couples de fils 314, 324 représente par exemple trente-deux couples de fils dans le cas d'un bus de données de trente-deux bits.

Le composant de commande 33 peut être réalisé au moyen d'une porte logique « OU ». Le composant de commande 33 peut être un élément d'un multiplexeur comme le premier multiplexeur 211 représenté sur la figure 2 pour le premier banc mémoire 21.

Le ou les premiers drivers 34 sont par exemple des drivers trois états. La fonction du premier driver 34 peut être réalisée par un premier amplificateur différentiel de lecture de la deuxième mémoire 300 par exemple. On peut utiliser un premier amplificateur différentiel comportant un ou deux étages, suivant la charge capacitive des bus parallèles de données 24, représentés sur la figure 2. Un deuxième bus de données mémoire 203 est connecté en sortie du driver 34. Le module de contrôle 311, 321, ou bien l'arbitre, peut activer une commande de sélection d'un bus de données 314, 324 d'un processeur 31, 32 ayant fait préalablement une requête de données. La commande de sélection est réalisée au moyen de commutateurs 315, 325 comme les commutateurs 214, 224, 234 représentés sur la figure 2. Sur la figure 3, on utilise une structure différentielle, chaque bus de donnée 314, 324 étant un bus de données différentiel 314, 324. Ainsi chaque commande de sélection utilise notamment deux éléments de commutation, par exemple des transistors, par commutateur 315, 325, soit un élément de commutation par ligne de bus différentiel. La commande de sélection permet de connecter la sortie du driver 34 à un bus de données 314, 324 lui-même connecté à un processeur 31, 32. En même temps que la commande de sélection est exécutée, un module de pré-charge 312, 322 du bus de données 314, 324 coupe la pré-charge. Le module de pré-charge 312, 322 a préalablement chargé la capacité parasite des lignes de bus de données 314, 324 avec une tension VDD ou tension d'alimentation. La tension VDD est alors la même dans chacune des lignes du bus de données 314, 324. Lorsque le signal de sortie de la mémoire est suffisamment fort, le ou les drivers 34 sont activés. Les drivers 34 déchargent alors une des lignes complémentaires du deuxième bus de données mémoire 203. La différence de tension est transmise sur le bus de données 314, 324. Puis la différence de tension est détectée par un deuxième amplificateur différentiel 316, 326 connecté d'une part à une entrée ou un bus de données Din du processeur 31, 32 et d'autre part au bus de données 314, 324. Le deuxième amplificateur différentiel 316, 326 peut tenir le rôle d'un driver pour le bus de données Din du processeur 31, 32. Dès que la sortie du deuxième amplificateur différentiel 316, 326 a basculé, le processeur 31, 32 peut enregistrer la donnée, le signal ayant récupéré en sortie du deuxième amplificateur différentiel 316, 326 sa pleine excursion. Le bus de données 314, 324 peut ensuite être remis en pré-charge par le module de pré-charge 312, 322. Le module de pré-charge 312, 322 peut être commandé par le module de contrôle 311, 321.

L'écriture d'une donnée en mémoire par le processeur 31, 32 peut s'effectuer de la même manière. Les données véhiculées par le bus de données 314, 324 sont dans ce cas contrôlées par le processeur 31, 32. Par exemple, une donnée devant être stockée en mémoire est codée sur un signal. Le signal sort du processeur 31, 32 par une sortie Dout du processeur 31, 32 puis est transmis en mode différentiel par un troisième amplificateur différentiel 317, 327. La pré-charge du bus de données 314, 324 étant coupée, une des lignes complémentaires du bus de données 314, 324 est chargée par la sortie du troisième amplificateur différentiel 317, 327. La différence de tension du bus de données 314, 324 se propage au deuxième bus de données mémoire 203. La différence de tension est alors détectée par le premier amplificateur différentiel 34 du quatrième banc mémoire 30. Une fois que le signal, détecté par le premier amplificateur différentiel 34, a basculé sur une sortie du premier amplificateur différentiel 34, la donnée contenue dans le signal est enregistrée dans le quatrième banc mémoire 30.

La réalisation de la mémoire partagée 20 en utilisant des moyens différentiels permet une efficacité accrue. En effet, il n'est pas nécessaire d'obtenir une pleine excursion du signal pour propager une donnée d'un bus à l'autre par exemple. Ceci permet un gain de temps ainsi qu'un gain d'énergie pendant le transfert des données de la mémoire partagée 20 vers les processeurs 31, 32.

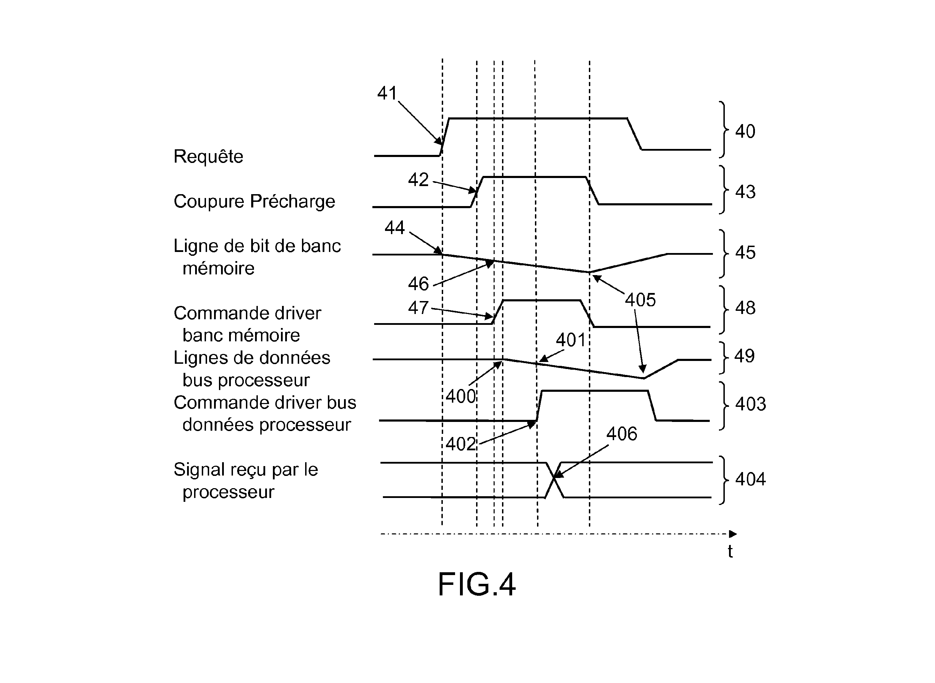

La figure 4 représente un exemple de différentes phases de la lecture d'une donnée par un processeur 31, 32, par exemple, sur le quatrième banc mémoire 30 de la mémoire partagée 20 selon l'invention. Les différentes phases sont présentées sous la forme de plusieurs chronogrammes 40, 43, 45, 48, 49, 403, 404 présentant les variations des différents signaux durant chaque phase de la lecture.

Un premier chronogramme 40 représente un signal transitant sur le premier bus d'adresses et de contrôle 200 représenté sur la figure 2. Une requête de lecture de données 41 modifie le signal du premier bus d'adresses et de contrôle 200.

Lorsque le processeur 31, 32 envoie une requête de lecture 41 au quatrième banc mémoire 30, ceci provoque le déclenchement de lecture d'une valeur sur le quatrième banc mémoire 30 et donc l'apparition d'un premier signal 44 sur une ligne de bit du quatrième banc mémoire 30. L'apparition du premier signal 44 sur la ligne de bit du quatrième banc mémoire 30 est représentée sur le deuxième chronogramme 45.

Un peu après l'envoi de la requête de lecture 41, la pré-charge du bus de données 314, 324 est coupée. La coupure 42 de la pré-charge, effectuée par le module de pré-charge 312, 322, est représentée sur un troisième chronogramme 43.

Lorsque le premier signal 44 sur les lignes de bit du quatrième banc mémoire 30 a atteint un premier niveau 46 suffisant pour permettre le bon fonctionnement du premier amplificateur différentiel 34 alors une première commande 47 des drivers 34 reliés au deuxième bus de données mémoire 203 est activée. La première commande 47 des drivers 34 est représentée sur un quatrième chronogramme 48.

Une fois la première commande 47 des drivers 34 exécutée par les drivers 34, les lignes du bus de données 314, 324 du processeur 31, 32 devant transporter l'information lue dans le quatrième banc mémoire 30 commencent à se décharger. Un cinquième chronogramme 49 représente l'apparition d'un deuxième signal 400 sur les lignes du bus de données 314, 324.

Lorsque la première commande 47 a été exécutée et que le deuxième signal 400 atteint un deuxième niveau 401 suffisant pour le fonctionnement du deuxième amplificateur différentiel 316, 326, alors une deuxième commande 402 est envoyée par le module de contrôle 311, 321 au driver 316, 326 du bus de données Din du processeur 31, 32. La deuxième commande 402 est représentée sur un sixième chronogramme 403.

L'exécution de la deuxième commande 402 par le driver 316, 326 entraîne un positionnement 406 de l'entrée Din du processeur 31, 32 à la valeur lue dans le quatrième banc mémoire 30. Le positionnement 406 de l'entrée Din du processeur 31, 32 est représenté sur un septième chronogramme 404 illustrant deux changements d'état possibles : un premier changement d'état de zéro vers un et un deuxième changement d'état de un vers zéro.

Une fois la valeur lue récupérée par le processeur 31, 32, le module de contrôle 311, 321 envoie une commande de mise en charge au module de pré-charge 312, 322 afin d'effectuer une mise en charge 405 des lignes des bus de données 314, 324 ainsi que les lignes du deuxième bus de données mémoire 203.

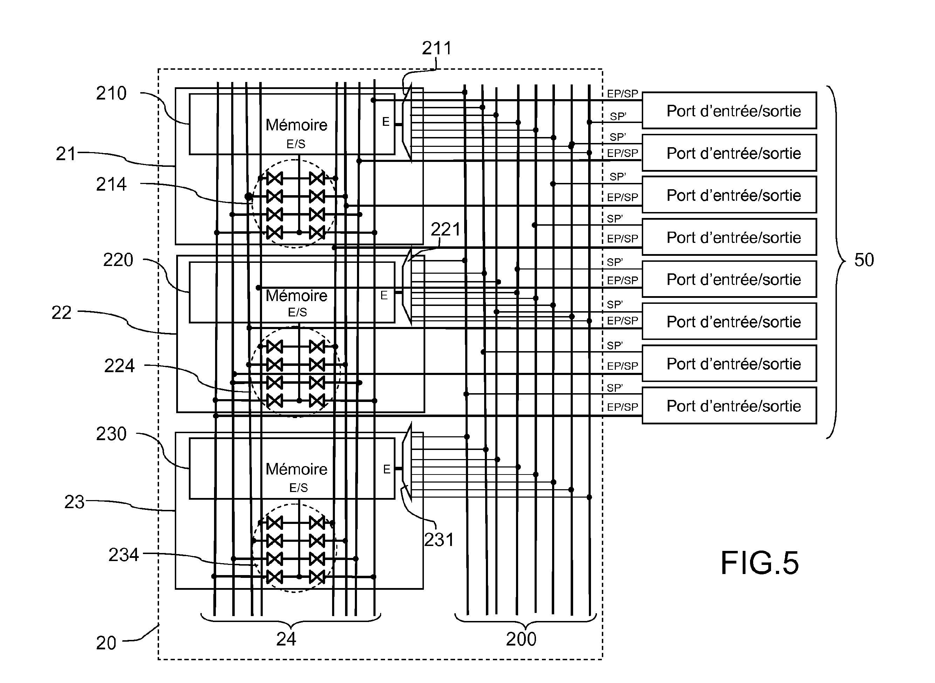

La figure 5 représente un autre mode d'utilisation de la mémoire partagée 20 selon l'invention. L'invention peut, en effet, s'appliquer à une mémoire partagée 20 réalisant un premier circuit à part entière. Le premier circuit comportant la mémoire partagée 20 peut être réalisé sur une deuxième puce à base de semi-conducteurs. Dans la figure 5, une représentation schématique d'un tel mode de réalisation est présentée. Les m processeurs 25 tels que représentés sur la figure 2 sont remplacés sur la figure 5 par une série de m ports d'entrée/sortie 50. Les m ports d'entrée/sortie 50 peuvent être connectés à un ou plusieurs circuits extérieurs au premier circuit comportant la mémoire partagée 20. Cette connexion peut s'effectuer classiquement par l'intermédiaire de ports de transfert connectés à des broches du circuit comportant la mémoire partagée 20. De manière générale, un port d'entrée/sortie est un élément permettant de connecter une puce à des composants électroniques extérieurs. Un port peut donc être un système réalisant un protocole d'échange et comportant des broches d'entrée/sortie ou par exemple un module capable de transformer des signaux entrant ou sortant de la puce de telle sorte qu'ils puissent être transmis par exemple par un couplage inductif ou capacitif.

Sur la figure 5, les m ports d'entrée/sortie 50 sont connectés à la mémoire partagée 20 par l'intermédiaire des entrées/sortie de données EP/SP de la mémoire partagée 20 et par l'intermédiaire des entrées d'adresses et de contrôle SP' de la mémoire partagée 20. La mémoire partagée 20 représentée sur la figure 5 est la même que celle représentée sur la figure 2.

Les ports d'entrée/sortie 50 peuvent, dans un premier exemple d'utilisation de la mémoire partagée 20 selon l'invention, être connectés à une puce de traitements. La puce de traitements, comportant par exemple m processeurs comme les processeurs 25 représentés sur la figure 2, peut être connectée avec les ports d'entrée/sortie 50 par une interconnexion en trois dimensions. Dans cette réalisation, la deuxième puce comportant la mémoire partagée 20 et la puce de traitements peuvent être physiquement collées l'une au-dessus de l'autre. Les connexions entre les deux puces peuvent se faire, soit par des vias à travers la puce du dessus, par exemple la deuxième puce mémoire, soit par des liaisons inductives, soit par des liaisons capacitives. Les vias sont des contacts entre deux niveaux de métaux, les vias pouvant notamment traverser toute la puce. Quant aux liaisons inductives, elles peuvent être réalisées à partir de petites bobines comportant une spire par exemple. Les liaisons capacitives peuvent être réalisées par des surfaces métalliques en regard l'une de l'autre. Ces connexions peuvent notamment être utilisées afin de connecter les bus de données et d'adresse des processeurs de la puce de traitements aux m bus parallèles de données 24 et aux bus parallèle d'adresses et de données 200 de la mémoire partagée 20.

Une telle puce mémoire est particulièrement pertinente avec les types d'interconnexion tels que décrits précédemment. De telles liaisons permettent notamment de connecter la mémoire partagée 20 avec la puce de traitements à travers de multiples liaisons. Les liaisons d'interconnexion entre les deux puces permettent d'assurer une bande passante bien supérieure à celle des mémoires actuelles. En effet, les mémoires actuelles sont notamment limitées par le nombre de broches du boîtier les intégrant et ne présentent qu'un seul port d'entrée/sortie.

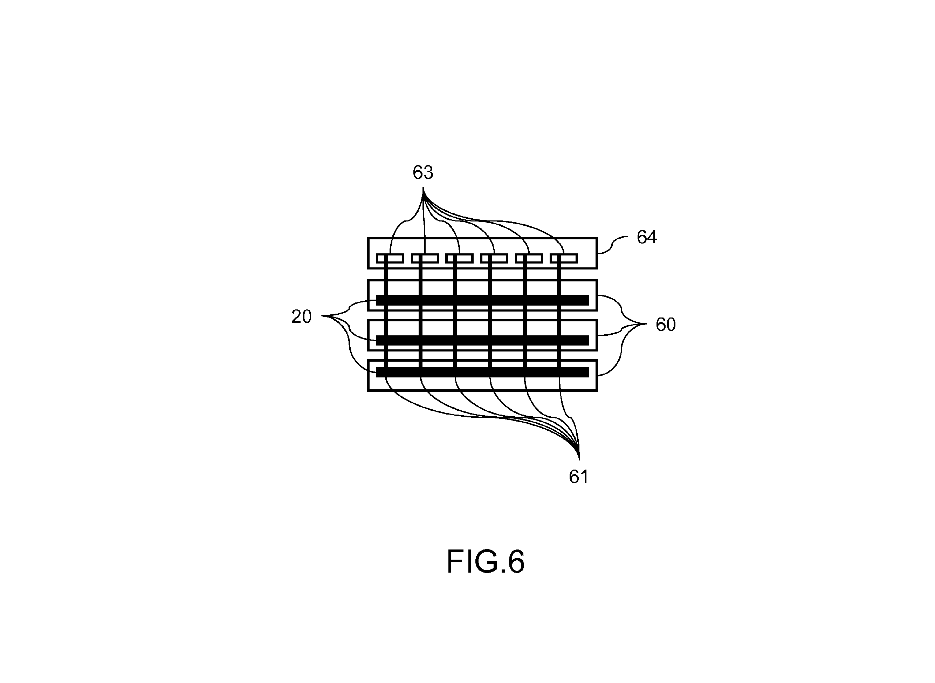

La figure 6 représente, de manière schématique, un deuxième exemple d'utilisation de la mémoire partagée 20 selon l'invention. On peut par exemple placer physiquement l'une au-dessus de l'autre plusieurs puces de mémoires 60 comportant une mémoire partagée 20 selon l'invention. Les m bus de données 24 et les bus d'adresses et de contrôle 200 représentés sur la figure 2 sont reliés à des bus de données et d'adresses reliant les mémoires partagées 20 des différentes puces de mémoires 60. Les bus de données et d'adresses reliant les mémoires partagées 20 peuvent traverser les puces de mémoire 60 de manière transverse par des vias 61 ou des liaisons capacitives ou encore des liaisons inductives. Les connexions avec des processeurs 63 situés par exemple sur une autre puce 64 située physiquement au-dessus des puces de mémoire 60 s'effectuent, par exemple, par l'intermédiaire des vias 61.

Une telle réalisation a pour avantage d'augmenter le nombre de mémoires mises à disposition des processeurs sans augmenter de manière considérable les surfaces d'interconnexions, notamment entre les puces et les processeurs.

La mémoire partagée 20 selon l'invention permet avantageusement à m processeurs 25 de pouvoir accéder à tous les bancs mémoire 21, 22, 23 de la mémoire partagée 20. Tous les m processeurs 25 peuvent notamment avoir accès simultanément à la mémoire partagée 20, chacun des m processeurs 25 accédant alors à un banc mémoire 21, 22, 23 différent.

La mémoire partagée 20 selon l'invention permet de réduire considérablement la surface d'interconnexion entre les mémoires et les processeurs d'un système multiprocesseur en permettant de faire passer cette interconnexion par exemple au-dessus des mémoires. De plus l'utilisation de mémoires simple port 210, 220, 230 permet avantageusement d'optimiser la surface des connexions nécessaires par rapport à une solution utilisant des mémoires multiports.

La mémoire partagée selon l'invention permet également un gain en vitesse de transfert des données ainsi qu'un gain en consommation d'énergie. En effet, la réduction de la longueur des connexions diminue leur capacité parasite et donc le temps de commutation des signaux ainsi que la consommation d'énergie. Le temps de commutation et la consommation d'énergie sont encore réduits par l'utilisation d'une structure différentielle où l'excursion de tension utilisée est réduite.

Une conception efficace en terme de couches de silicium utilisées notamment pour réaliser les connexions dans une puce comportant une mémoire partagée 20 selon l'invention, réduit avantageusement les coûts de production d'une telle mémoire partagée.

Avantageusement, la mémoire partagée 20 selon l'invention a un mode de fonctionnement de type MIMD, acronyme pour l'expression anglo-saxonne Multiple Instructions, Multiple Data, signifiant « instructions multiples, données multiples », permettant à des programmes différents s'exécutant sur les m processeurs 25 d'accéder simultanément à des données différentes contenues dans la mémoire partagée 20.

## Revendications

1. Mémoire partagée (20), réalisée sur un premier circuit intégré à base de semi-conducteurs, comportant :
• un nombre entier m, supérieur à un, d'interfaces d'entrées/sorties (EP/SP, SP'), chacune des m interfaces d'entrée/sortie comprenant 1 entrée/sortie de données (EP/SP) et 1 entrée d'adresses et de contrôle (SP');
• un nombre entier p, supérieur à un, de bancs mémoire (21, 22, 23, 30), chaque banc mémoire (21, 22, 23, 30) comprenant :
- une mémoire (210, 220, 230, 300), comportant une entrée/sortie de données (E/S) et une entrée d'adresses et de contrôle (E) ;
- un bloc de m commutateurs (214, 224, 234), chacun des m commutateurs (214, 224, 234) étant connecté via un bus de données mémoire (213, 223, 233) à l'entrée/sortie de données (E/S) de la mémoire (210, 220, 230, 300),
la mémoire partagée (20) étant **caractérisée en ce qu'**elle comporte:
• m bus de données bidirectionnels (24), chacun des m bus de données (24) étant connecté respectivement à l'une des m entrées/sorties de données (EP/SP) de la mémoire partagée (20) d'une part et étant connecté, d'autre part, à chacun des p bancs de mémoires par l'intermédiaire de l'un des m commutateurs de chaque banc mémoire,
• m bus d'adresses et de contrôle (200), chacun étant connecté à l'une des m entrées d'adresses et de contrôle de la mémoire partagée (20) d'une part, et étant connecté d'autre part à l'entrée d'adresses et de contrôle (E) de chacun des p bancs mémoire par l'intermédiaire d'un multiplexeur (211, 221, 231) prévu dans chaque banc mémoire.

2. Mémoire partagée (20) selon la revendication 1, **caractérisée en ce que** chaque multiplexeur (211, 221, 231) d'un banc de mémoire a une sortie connectée à l'entrée d'adresses et de contrôle (E) de la mémoire (210, 220, 230, 300), des entrées du multiplexeur (211, 221, 231) étant connectées à chacun des bus d'adresses et de contrôle (200), le multiplexeur sélectionnant le bus d'adresse et de contrôle (200) devant commander le banc mémoire (21, 22, 23, 30).

3. Mémoire partagée (20) selon la revendication 1, **caractérisée en ce que** le premier circuit intégré comporte plusieurs couches de métaux, les p bancs mémoires (21, 22, 23) utilisant une ou plusieurs couches de métaux, les m bus de données (24) et les bus d'adresses et de contrôle (200) sont réalisés dans des couches de métaux superposées aux couches comportant les p bancs mémoires (21, 22, 23, 30).

4. Mémoire partagée (20) selon l'une quelconque des revendications 1 à 3, **caractérisée en ce que** les m interfaces d'entrées/sortie (EP/SP, SP') de la mémoire partagée (20) sont aptes à être connectées à des entrées/sorties de m processeurs (25) internes au premier circuit intégré.

5. Mémoire partagée (20) selon l'une quelconque des revendications précédentes, **caractérisée en ce que** les m bus de données (24) et les bus d'adresses et de contrôle (200) sont des bus parallèles.

6. Mémoire partagée (20) selon l'une quelconque des revendications 1 à 5, **caractérisée en ce que** les m bus de données (24) sont des bus différentiels.

7. Mémoire partagée (20) selon l'une quelconque des revendications précédentes, **caractérisée en ce que** les mémoires (210, 220, 230, 300) sont des mémoires à simple port.

8. Mémoire partagée (20) selon l'une quelconque des revendications précédentes, **caractérisée en ce que** les mémoires (210, 220, 230, 300) sont des mémoires de type SRAM, acronyme pour l'expression anglo-saxonne Static Random Access Memory, signifiant mémoire vive statique.

9. Circuit intégré à base de semi-conducteurs **caractérisé en ce qu'**il comporte :
• une mémoire partagée selon l'une quelconque des revendications 1 à 8;
• m ports d'entrée/sortie (50) permettant la connexion du circuit intégré avec des composants électroniques extérieurs au circuit intégré, chacun des m ports (50) étant relié à l'une des m interfaces d'entrées/sorties (EP/SP, SP') de la mémoire partagée (20) ;

10. Circuit intégré à base de semi-conducteurs, **caractérisé en ce qu'**il comprend une mémoire partagée selon l'une quelconque des revendications 1 à 8, et m processeurs (25), chacun des m processeurs (25) étant connecté à l'une des m interfaces d'entrée/sortie (EP/SP, SP') de la mémoire partagée (20).

11. Circuit intégré à base de semi-conducteurs, **caractérisé en ce qu'**il comprend une mémoire partagée selon l'une quelconque des revendications 1 à 8, ledit circuit intégré étant physiquement en contact avec un deuxième circuit intégré comprenant m processeurs (25), chacun des m processeurs (25) étant connecté à l'une des m interfaces d'entrée/sortie (EP/SP, SP') de la mémoire partagée (20), et **en ce que** le deuxième circuit intégré est physiquement en contact avec ledit premier circuit intégré.

12. Circuit intégré à base de semi-conducteurs selon la revendication 11, **caractérisé en ce que** les m interfaces d'entrées/sorties (EP/SP, SP') de la mémoire partagée sont connectées avec les m processeurs (25) au moyen de vias.

13. Circuit intégré à base de semi-conducteurs selon la revendication 11, **caractérisé en ce que** les m interfaces d'entrées/sorties (EP/SP, SP') de la mémoire partagée sont connectées avec les m processeurs (25) au moyen de liaisons inductives.

14. Circuit intégré à base de semi-conducteurs selon la revendication 11, **caractérisé en ce que** les m interfaces d'entrées/sorties de la mémoire partagée sont connectées avec les m processeurs (25) au moyen de liaisons capacitives.

15. Circuits intégrés à base de semi-conducteurs, **caractérisés en ce qu'**ils comportent chacun un ou plusieurs des p bancs mémoires (21, 22, 23, 302) selon l'une quelconque des revendications 1 à 8, lesdits circuits intégrés étant situés les uns au dessus des autres, les m bus de données (24) et les bus d'adresses et de contrôle (200) étant positionnés transversalement par rapport aux circuits intégrés.

## Patentansprüche

1. Gemeinsam benutzter Speicher (20), realisiert auf einem ersten integrierten Schaltkreis auf der Basis von Halbleitern, der aufweist:
• eine ganze Zahl m größer als 1 von Eingangs-/Ausgangsschnittstellen (EP/SP, SP'), wobei jede der m Eingangs-/Ausgangsschnittstellen 1 Dateneingang/-ausgang (EP/SP) und 1 Adress- und Kontrolleingang (SP') umfasst,
• eine ganze Zahl p größer als 1 von Speicherbänken (21, 22, 23, 30), wobei jede Speicherbank (21, 22, 23, 30) umfasst:
- einen Speicher (210, 220, 230, 300), der einen Dateneingang/-ausgang (E/S) und einen Adress- und Kontrolleingang (E) aufweist,
- einen Block von m Umschaltern (214, 224, 234), wobei jeder der m Umschalter (214, 224, 234) über einen Speicherdatenbus (213, 223, 233) mit dem Dateneingang/-ausgang (E/S) des Speichers (210, 220, 230, 300) verbunden ist,
wobei der gemeinsam benutzte Speicher (20) **dadurch gekennzeichnet ist, dass** er aufweist:
• m bidirektionale Datenbusse (24), wobei jeder der m Datenbusse (24) einerseits jeweils mit einem der m Dateneingänge/-ausgänge (EP/SP) des gemeinsam benutzten Speichers (20) verbunden ist und andererseits mit jedem der p Speicherbänke über einen der m Umschalter jeder Speicherbank verbunden ist,
• m Adress- und Kontrollbusse (200), wobei einerseits jeder mit einem der m Adress- und Kontrolleingänge des gemeinsam benutzten Speichers (20) verbunden ist und andererseits mit dem Adress- und Kontrolleingang (E) jeder der p Speicherbänke über einen in jeder Speicherbank vorgesehenen Multiplexer (211, 221, 231) verbunden ist.

2. Gemeinsam benutzter Speicher (20) nach Anspruch 1, **dadurch gekennzeichnet, dass** jeder Multiplexer (211, 221, 231) einer Speicherbank einen mit dem Adress- und Kontrolleingang (E) des Speichers (210, 220, 230, 300) verbundenen Ausgang hat, wobei Eingänge des Multiplexers (211, 221, 231) mit jedem der Adress- und Kontrollbusse (200) verbunden sind, wobei der Multiplexer den Adress- und Kontrollbus (200) auswählt, der die Speicherbank (21, 22, 23, 30) steuern muss.

3. Gemeinsam benutzter Speicher (20) nach Anspruch 1, **dadurch gekennzeichnet, dass** der erste integrierte Schaltkreis mehrere Metallschichten aufweist, wobei die p Speicherbänke (21, 22, 23) eine oder mehrere Metallschichten verwenden, wobei die m Datenbusse (24) und die Adress- und Kontrollbusse (200) in Metallschichten realisiert sind, die auf den Schichten liegen, die die p Speicherbänke (21, 22, 23, 30) aufweisen.

4. Gemeinsam benutzter Speicher (20) nach einem der Ansprüche 1 bis 3, **dadurch gekennzeichnet, dass** die m Eingangs-/Ausgangsschnittstellen (EP/SP, SP') des gemeinsam benutzten Speichers (20) imstande sind, mit Eingängen/Ausgängen von m internen Prozessoren (25) des ersten integrierten Schaltkreises verbunden zu sein.

5. Gemeinsam benutzter Speicher (20) nach einem der vorangehenden Ansprüche, **dadurch gekennzeichnet, dass** die m Datenbusse (24) und die Adress- und Kontrollbusse (200) parallele Busse sind.

6. Gemeinsam benutzter Speicher (20) nach einem der Ansprüche 1 bis 5, **dadurch gekennzeichnet, dass** die m Datenbusse (24) Differentialbusse sind.

7. Gemeinsam benutzter Speicher (20) nach einem der vorangehenden Ansprüche, **dadurch gekennzeichnet, dass** die Speicher (210, 220, 230, 300) Speicher mit einfachem Port sind.

8. Gemeinsam benutzter Speicher (20) nach einem der vorangehenden Ansprüche, **dadurch gekennzeichnet, dass** die Speicher (210, 220, 230, 300) Speicher vom Typ SRAM - Abkürzung für den angelsächsischen Ausdruck Static Random Access Memory, was statisches RAM bedeutet - sind.

9. Integrierter Schaltkreis auf der Basis von Halbleitern, **dadurch gekennzeichnet, dass** er aufweist:
• einen gemeinsam benutzten Speicher nach einem der Ansprüche 1 bis 8,
• m Eingangs-/Ausgangsbusse (50), die die Verbindung des integrierten Schaltkreises mit elektronischen Komponenten außerhalb des integrierten Schaltkreises erlauben, wobei jeder der m Ports (50) mit einer der m Eingangs-/Ausgangsschnittstellen (EP/SP, SP') des gemeinsam benutzten Speichers verbunden ist.

10. Integrierter Schaltkreis auf der Basis von Halbleitern, **dadurch gekennzeichnet, dass** er einen gemeinsam benutzten Schaltkreis nach einem der Ansprüche 1 bis 8 und m Prozessoren (25) umfasst, wobei jeder der m Prozessoren (25) mit einer der m Eingangs-/Ausganasschnittstellen (EP/SP, SP') des gemeinsam benutzten Speichers (20) verbunden ist.

11. Integrierter Schaltkreis auf der Basis von Halbleitern, **dadurch gekennzeichnet, dass** er einen gemeinsam benutzten Schaltkreis nach einem der Ansprüche 1 bis 8 umfasst, wobei der integrierte Schaltkreis mit einem zweiten integrierten Schaltkreis physisch im Kontakt ist, der m Prozessoren (25) umfasst, wobei jeder der m Prozessoren (25) mit einer der m Eingangs-/Ausgangsschnittstellen (EP/SP, SP') des gemeinsam benutzten Speichers (20) verbunden ist, und dass der zweite integrierte Schaltkreis mit dem ersten integrierten Schaltkreis physisch im Kontakt ist.

12. Integrierter Schaltkreis auf der Basis von Halbleitern nach Anspruch 11, **dadurch gekennzeichnet, dass** die m Eingangs-/Ausgangsschnittstellen (EP/SP, SP') des gemeinsam benutzten Speichers (20) mit den m Prozessoren (25) mit Hilfe von Durchkontaktierungen verbunden sind.

13. Integrierter Schaltkreis auf der Basis von Halbleitern nach Anspruch 11, **dadurch gekennzeichnet, dass** die m Eingangs-/Ausgangsschnittstellen (EP/SP, SP') des gemeinsam benutzten Speichers mit den m Prozessoren (25) mit Hilfe induktiver Verbindungen verbunden sind.

14. Integrierter Schaltkreis auf der Basis von Halbleitern nach Anspruch 11, **dadurch gekennzeichnet, dass** die m Eingangs-/Ausgangsschnittstellen des gemeinsam benutzten Speichers mit den m Prozessoren (25) mit Hilfe von kapazitiven Verbindungen verbunden sind.

15. Integrierte Schaltkreise auf der Basis von Halbleitern, **dadurch gekennzeichnet, dass** sie jeder eine oder mehrere der p Speicherbänke (21, 22, 23, 302) nach einem der Ansprüche 1 bis 8 aufweisen, wobei sich die integrierten Schaltkreise übereinander befinden, wobei die m Datenbusse (24) und die Adress- und Kontrollbusse (200) im Verhältnis zu den integrierten Schaltkreisen quer angeordnet sind.

## Claims

1. A shared memory (20), made on a first integrated circuit based on semi-conductors, comprising:
• an integer number m, greater than one, of input/output interfaces (EP/SP, SP'), each of the m input/output interfaces comprising 1 data input/output (EP/SP) and 1 address and control input (SP');
• an integer number p, greater than one, of memory banks (21, 22, 23, 30), each memory bank (21, 22, 23, 30) comprising:
- a memory (210, 220, 230, 300) comprising a data input/output (E/S) and an address and control input (E);
- a block of m switches (214, 224, 234), each of the m switches (214, 224, 234) being connected via a memory data bus (213, 223, 233) to the data input/output (E/S) of the memory (210, 220, 230, 300),
the shared memory (20) being **characterised in that** it comprises:
• m bidirectional data buses (24), each of the m data buses (24) being respectively connected to one of the m data inputs/outputs (EP/SP) of the shared memory (20) on the one hand and being connected, on the other hand, to each of the p memory banks by means of one of the m switches of each memory bank,
• m address and control buses (200), each being connected to one of the m address and control inputs of the shared memory (20) on the one hand, and being connected on the other hand to the address and control input (E) of each of the p memory banks by means of a multiplexer (211, 221, 231) provided in each memory bank.

2. The shared memory (20) according to Claim 1, **characterised in that** each multiplexer (211, 221, 231) of a memory bank has an output connected to the address and control input (E) of the memory (210, 220, 230, 300), inputs (211, 221, 231) of the multiplexer being connected to each of the address and control buses (200), the multiplexer selecting the address and control bus (200) that has to control the memory bank (21, 22, 23, 30).

3. The shared memory (20) according to Claim 1, **characterised in that** the first integrated circuit comprises several layers of metals, the p memory banks (21, 22, 23) using one or more layers of metals, the m data buses (24) and the address and control buses (200) are made in layers of metals overlaid on the layers comprising the p memory banks (21, 22, 23, 30).

4. The shared memory (20) according to any of Claims 1 to 3, **characterised in that** the m input/output interfaces (EP/SP, SP') of the shared memory (20) are able to be connected to inputs/outputs of m processors (25) internal to the first integrated circuit.

5. The shared memory (20) according to any of the preceding claims, **characterised in that** the m data buses (24) and the address and control buses (200) are parallel buses.

6. The shared memory (20) according to any of Claims 1 to 5, **characterised in that** the m data buses (24) are differential buses.

7. The shared memory (20) according to any of the preceding claims, **characterised in that** the memories (210, 220, 230, 300) are single-port memories.

8. The shared memory (20) according to any of the preceding claims, **characterised in that** the memories (210, 220, 230, 300) are memories of the SRAM type, the acronym standing for the expression Static Random Access Memory.

9. An integrated circuit based on semi-conductors **characterised in that** it comprises:
• a shared memory according to any of claims 1 to 8;
• m input/output ports (50) enabling connection of the integrated circuit to electronic components on the outside of the integrated circuit, each of the m ports (50) being linked to one of the m input/output interfaces (EP/SP, SP') of the shared memory (20).

10. The integrated circuit based on semi-conductors, **characterised in that** it comprises a shared memory according to any of Claims 1 to 8, and m processors (25), each of the m processors (25) being connected to one of the m input/output interfaces (EP/SP, SP') of the shared memory (20).

11. The integrated circuit based on semi-conductors, **characterised in that** it comprises a shared memory according to any of Claims 1 to 8, said integrated circuit being physically in contact with a second integrated circuit comprising m processors (25), each of the m processors (25) being connected to one of the m input/output interfaces (EP/SP, SP') of the shared memory (20), and **in that** the second integrated circuit is physically in contact with said first integrated circuit.

12. The integrated circuit based on semi-conductors according to Claim 11, **characterised in that** the m input/output interfaces (EP/SP, SP') of the shared memory are connected to the m processors (25) by vias.

13. The integrated circuit based on semi-conductors according to Claim 11, **characterised in that** the m input/output interfaces (EP/SP, SP') of the shared memory are connected to the m processors (25) by inductive links.

14. The integrated circuit based on semi-conductors according to Claim 11, **characterised in that** the m input/output interfaces of the shared memory are connected to the m processors (25) by capacitive links.

15. Integrated circuits based on semi-conductors, **characterised in that** they each comprise one or more of the p memory banks (21, 22, 23, 302) according to any of Claims 1 to 8, said integrated circuits being situated one above another, the m data buses (24) and the address and control buses (200) being positioned transversely to the integrated circuits.
